# EUROPÄISCHE PATENTSCHRIFT

(11) **EP 0 798 777 B1**
(45) Veröffentlichungstag und Bekanntmachung des Hinweises auf die Patenterteilung: **26.05.2004**
(21) Anmeldenummer: 97104276.7
(22) Anmeldetag: 13.03.1997
(51) Int. Cl.: H01L 21/768, H01L 21/285

(54) **Verfahren zur Metallisierung von Submikron Kontaktlöchern in Halbleiterkörpern**
Method of metallizing submicronic contact holes in semiconductor body
Procédé de métallisation de trous de contact submicroniques dans un corps semi-conducteur

(30) Priorität: 29.03.1996 DE 19612725
(43) Veröffentlichungstag der Anmeldung: 01.10.1997
(73) Patentinhaber: Infineon Technologies AG, 81669 München (DE)
(72) Erfinder: Hieber, Konrad, Dr. Dipl.-Phys., 85630 Neukeferloh (DE); Ireichel, Helmuth, Dipl.-Ing. (FH), 86156 Augsburg (DE); Körner, Heinrich, Dr. Dipl.-Chem., 83052 Bruckmühl (DE)
(74) Vertreter: Kindermann, Peter, Dipl.-Ing.

(56) Entgegenhaltungen:
- US-A- 5 397 742
- US-A- 5 462 895
- PATENT ABSTRACTS OF JAPAN vol. 016, no. 408 (E-1255), 28.August 1992 & JP 04 137621 A (TOSHIBA CORP), 12.Mai 1992,

## Beschreibung

Die Erfindung betrifft ein Verfahren zur Metallisierung von Submikron-Kontaktlöchern in Halbleiterkörpern, bei denen in das Submikron-Kontaktloch ein Metall abgeschieden wird.

Solche Verfahren sind in der Halbleitertechnologie zunehmend notwendig, weil häufig mehrere leitende Schichten, die mit zunehmendem Integrationsgrad in mehreren Ebenen angeordnet sind, verwendet werden. Entsprechend strukturiert dienen sie als Leitbahnen für elektrische Ströme. Gegeneinander sind diese Bahnen durch geeignete nichtleitende Schichten isoliert. Sollen Leitbahnen, die in unterschiedlichen Ebenen angeordnet sind, untereinander oder mit dem Si-Substrat leitend verbunden werden, so ist in der zwischenliegenden Isolationsschicht eine Öffnung (Kontaktloch) zu strukturieren. Manchmal ist eine direkte Verbindung aber aus physikalischen Gründen ausgeschlossen. Zum Beispiel kann ein n⁺-dotiertes Siliziumsubstrat nicht direkt mit einer AlSi (1%)-Leitbahn kontaktiert werden. Es entstünde eine Diode statt einem Ohm schen Kontakt, da das sich ausscheidende Silizium durch Al p⁺-dotiert wird. In solchen Fällen muß über eine Zwischenschicht eine indirekte Verbindung hergestellt werden. Typisch bestehen diese Zwischenschichten, die einen ohm schen Kontakt zum Silizium herstellen sollen, aus Titan (Ti), Titansilizid (TiSₓ mit x ≤ 2) oder Titan/Wolfram (TiW). Zusätzlich ist eine Barriereschicht notwendig, die vorzugsweise aus Titannitrid (TiN) oder TiW besteht. Beide genannten Materialien sind mit einem spezifischen Widerstand von 70-150 µΩcm relativ hochohmig.

Mit zunehmender Miniaturisierung der Mikroelektronikbausteine ("sub-µm-Technologie") werden die Durchmesser der Verbindungslöcher immer kleiner, wegen der gleichzeitig notwendigen besseren Planarisierung der Isolationsschichten jedoch auch immer tiefer. Aus Zuverlässigkeitsgründen und wegen des Trends zu schnelleren Schaltzeiten und höheren Stromdichten ist es notwendig, die Verbindungslöcher lunkerfrei mit einem gut leitenden Material zu metallisieren und gleichzeitig für reproduzierbar niederohmige Kontakte zu allen in Frage kommenden Schichtmaterialien zu sorgen.

Wegen der weiter ansteigenden Lochaspektverhältnisse (= Verhältnis Tiefe/Durchmesser) kann diese Kontaktmetallisierung nicht mehr durch Abscheidung des üblichen Schichtaufbaus (z.B. Ti/TiN/W) erfolgen, da die gängigen Sputterverfahren für Ti/TiN keine konforme Abscheidung ermöglichen und somit immer einen negativen Flankenwinkel hinterlassen, der auch bei der konformen Wolfram-CVD-Abscheidung zur Lunkerbildung führt. Bedenkt man, daß bei einem Kontaktlochdurchmesser von z. B. o.3 µm mindestens 50 nm Ti und 80 nm TiN abgeschieden werden müssen, um am Kontaktlochboden noch eine ausreichende, zusammenhängende Schicht zu erhalten, dann verbleibt für das niederohmige stromtragende Wolfram ein minimaler Restdurchmesser des Kontaktloches von kleiner 0.1 µm. Eine lunkerfreie Auffüllung ist dabei ausgeschlossen. Darüber hinaus ist diese beschriebene Prozeßsequenz kosten- und zeitintensiv.

Bei der bekannten, konventionellen Metallisierung (Sputterverfahren) werden eine oder mehrere Metallschichten (z.B. AlSi oder Ti/TiN/AlSiCu) durch physikalische Verfahren (z.B. Sputtern, Aufdampfen) abgeschieden und durch geeignete Fototechnik- und Ätzschritte aus ihnen Strukturen erzeugt. Aufgrund der schlechten Kantenbedeckung dieser Verfahren ist diese Kontaktmetallisierung bereits bei Aspektverhältnissen von etwa eins nur mit zusätzlichen Prozeßschritten (z.B. Aufweiten oder Anschrägen der oberen Kontaktlochhälfte) und mit Erschwernissen bei nachfolgenden Prozessen (z.B. bei der Planarisierung) realisierbar. Für Metallisierungen in Kontaktlöchern mit Aspektverhältnissen > 1 sowie bei erhöhten Stromdichten ist sie nicht mehr zuverlässig einsetzbar. Weiterentwicklungen der Sputter-Technik wie z. B. "collimated sputtern" (= gerichtetes Abscheiden durch geeignete, z. B. mechanische Blenden) [15] führen zwar zu dickeren Schichten am Kontaktlochboden als die konventionellen Verfahren, jedoch steigen dadurch auch die resultierenden Aspektverhältnisse weiter an, da die auf der horizontalen Isolatorfläche abgeschiedene Schichtdicke jene im Kontaktlochboden immer übersteigt. Damit verschärfen sich die Anforderungen an die Konformität und die Planarisierung der nachfolgenden Prozesse nur weiter.

Die Metallisierung von Kontakten durch ganzflächige CVD-Wolframabscheidung (aus z. B. WF₆ /H₂) und Rückätzung, wie z.B. in [1] beschrieben, ist in industrieller Erprobung und Anwendung relativ weit fortgeschritten. Sie stellt jedoch ein aufwendiges und deswegen kostenintensives Verfahren dar, da sie aus folgenden Einzelschritten besteht:
b1) Sputtern einer Kontaktschicht (z.B. Ti) zur Erzeugung einer niederohmigen Kontaktzone an den Grenzflächen zu Silizium oder Aluminium.
b2) Sputtern einer Barrierenschicht (z.B. TiN oder TiW), um den Angriff der reaktiven WF₆ -Moleküle auf die Ti-, Aloder Si-Schichten zu verhindern.
b3) Ganzflächige, konforme Abscheidung der CVD-Wolframschicht, gefolgt von einem Ätzschritt, mit dem das Metall von der horizontalen Isolatorschichten wieder entfernt wird.

Aufgrund der schlechten Kantenbedeckung der beiden benötigten Sputterprozesse (b1 und b2) müssen diese Schichten mit steigendem Aspektverhältnis immer dicker abgeschieden werden, um in den relevanten Zonen der Kontaktlöcher eine gerade noch ausreichende Schichtdicke zu erhalten und so die Barrierenfunktion sicherzustellen.

Die geometrische Ausgangssituation für die (eigentlich konforme) Wolframabscheidung wird denkbar ungünstiger, eine lunkerfreie Auffüllung ist nicht mehr möglich und zudem sinkt mit weiter abnehmendem Lochdurchmesser der resultierende volumenanteil des niederohmigen Wolframmetalls an der Kontaktmetallisierung. Selbst bei Verfügbarkeit von konform abgeschiedenen CVD-Kontakt- und -Barrierenschichten, wie z.B. in der Europäischen Patentanmeldung Nr. 90106139 beschrieben, verbleibt ein aufwendiges und kostenintensives Verfahren, dessen Durchführung allenfalls in verschiedenen Kammern einer Mehrkammer-Hochvakuumanlage praktikabel erscheint.

Wird anstelle von Wolfram ein anderes Metall (z.B. Aluminium) oder ein Metalloid (z.B. TiN), welche prinzipiell auch über CVD-Verfahren konform abgeschieden werden können (siehe z. B. Europäische Patentanmeldung Nr. 90106139) zur Kontaktmetallisierung verwendet, so gilt ebenfalls die obige Aussage, da aus analogen Argumenten wiederum eine Mehrschichtmetallisierung herangezogen werden muß. Von besonderer Bedeutung ist diese Aussage bei Verwendung von CVD-TiN. Hier wurde zwar die prinzipielle Machbarkeit einer Auffüllung mit einem CVD-TiNplug beschrieben [3], jedoch ist dieses Verfahren ausschließlich für Kontakte einsetzbar, bei denen zuvor wie bei der Salizid- (=self aligned silicide) Technologie die eigentliche Kontakt- und Übergangszone in einem vorgelagerten Mehrstufenprozeß gebildet wurde. Das in [3] beschriebene Verfahren ist nicht anwendbar für Kontakte zu Poly- und einkristallinem Silizium (zu hohe Übergangswiderstände) und auch nicht zur Metallisierung von Viaholes (dito und zu hohe Prozeßtemperaturen).

Aus US-A-5 462 895 ist ein Verfahren zur Metallisierung von Submikron-Kontaktlöchern in Halbleiterkörpern bekannt, wobei im Submikron-Kontaktloch Metall in einem ersten Verfahrensschritt durch einen einzigen CVD-Prozess innerhalb einer einzigen CVD-Kammer abgeschieden wird. Im wesentlichen wird hierbei zunächst eine titanreiche TiN-Schicht und eine stöchiometrische TiN-Schicht im Kontaktloch abgeschieden.

Anschließend wird in einem zweiten Verfahrensschritt eine W-Schicht als Füllmaterial in das Kontaktloch eingebracht und abschließend in einem dritten Verfahrenschritt mittels eines Ausheilvorgangs die titanreiche TiN-Schicht in eine TiSi₂-Schicht umgewandelt.

Alternativ kann gemäß US-A-5 462 895 an Stelle der titanreichen TiN-Schicht auch eine Ti-Schicht oder eine titanreiche TiSiₓ-Schicht abgeschieden und in eine TiSi₂-Schicht umgewandelt werden.

Demgegenüber liegt der Erfindung die Aufgabe zugrunde ein Verfahren zur Metallisierung von Submikron-Kontaktlöchern in Halbleiterkörpern zu schaffen, welches zuverlässig, effektiv und kostengünstig ist.

Erfindungsgemäß wird diese Aufgabe durch die Maßnahmen des Patentanspruchs 1 gelöst.

Bei der selektiven CVD von Metallen und Siliziden wird angestrebt, daß ein bestimmtes, gut leitendes Material selektiv (d. h. ausschließlich) auf bestimmten, zu kontaktierenden Substraten (wie Si, Silizid- oder Metalloberflächen) aufwächst. Liegt am Boden der Verbindungslöcher ein dafür geeignetes Substrat vor, ist eine direkte, lunkerfreie Auffüllung der Löcher möglich. Bei keinem der hier explizit genannten und allen weiteren vorstellbaren Verfahren konnte bisher die permanent reproduzierbare Durchführung unter Fertigungsbedingungen realisiert werden, weshalb diese Methoden industriell nicht genutzt werden.

Ihre Hauptnachteile sind:
- Die Notwendigkeit einer reproduzierbaren und effizienten Reinigung der Kontaktzonen vor der eigentlichen Abscheidung, die mit zunehmendem Aspektverhältnis der Verbindungslöcher immer schwieriger wird.
- Die bei Verwendung von bestimmten, agressiven Chemikalien, wie z.B. WF₆, massiven Grenzflächenreaktionen insbesondere bei Kontakt mit Silizium, die zu inakzeptabel hohen Leckströmen in Dioden und Transistoren führen.
- Die resultierenden engen Prozessfenster, z.B. verursacht durch leicht und häufig erfolgende "nichtselektive" Abscheidung auf Isolatoroberflächen, die durch dort vorhandene Nukleationskeime hervorgerufen wird.
- Die unterschiedlich tiefen Verbindungslöcher können nicht oder nur durch weitere aufwendige Maßnahmen im gleichen Ausmaß (idealerweise bis Isolatoroberkante) aufgefüllt werden, da das Füllmaterial gleichmäßig vom Kontaktboden in vertikale Richtung wächst.

Der vorliegenden Erfindung liegt die Aufgabe zugrunde, ein zuverlässiges und in zukünftigen Technologien uneingeschränkt einsetzbares Verfahren anzugeben, das insbesondere die oben beschriebenen genannten Verfahren ersetzen kann und deren Nachteile nicht aufweist.

Das erfindungsgemäße Verfahren zeichnet sich dadurch aus, daß die Kontaktmetallisierung durch einen einzigen hochkonformen CVD-Prozeß, mit dem in einer einzigen CVD-Kammer sowohl die Kontaktschicht als auch das niederohmige Kontaktfüllmaterial abgeschieden werden, erzeugt wird. Es handelt sich um ein Verfahren, bei dem zunächst eine CVD-Ti- oder CVD-Ti Si-Schicht abgeschieden wird und unmittelbar darauf in der gleichen Kammer durch Zufügen weiterer Reaktionspartner oder Variation der Abscheideparameter eine konforme, niederohmige (= 20-40 µΩcm) CVD-TiSi₂-Schicht abgeschieden wird. Ihre Dicke richtet sich nach dem verbleibenden Restdurchmesser der Verbindungslöcher. Zur Vollendung der Metallisierung kann sich ein Rückätzprozeß anschließen, mit dem die auf den horizontalen Isolatorflächen abgeschiedenen Ti/TiSi₂-"Stöpsel" im Verbindungsloch verbleibt. Die weitere Verdrahtung erfolgt wie üblich durch Aufbringen und Strukturieren von bekannten niederohmigen Materialien wie AlSi oder TiN/AlSiCu durch z.B. Sputtern. Bei Kontaktlöchern mit Durchmessern ≤ 0.4 µm erübrigt sich das Rückätzen, da die abgeschiedene Ti/TiSix-Schichtdicke ca. 0.2 beträgt. Man sputtert darauf z.B. TiN/AlSiCu und strukturiert das Schichtpaket Ti/TiSiₓ /TiN/AlSiCu wie bisher in einem Arbeitsgang. Alternativ kann auch anstelle des Rückätzprozesses in Ebenen, wo nur kurze metallische Verbindungen herzustellen sind, die CVD-Ti/TiSi₂ Schicht gleich mit den bekannten Lithographie-/Ätzverfahren strukturiert werden, so daß Kontaktmetallisierung und Leitbahn in einem Arbeitsgang entstehen.

Optionell kann dem erfingungsgemäßen Verfahren
- vorausgehen: eine Reinigung der Kontaktzonen (entweder naßchemisch oder trocken, je nach Bedarf und Substrat mit bevorzugter chemischer oder physikalischer Komponente, wenn möglich bevorzugt "in-situ" in Mehrkammeranlagen, wie in der Europäischen Patentanmeldung Nr. 90106139 oder DE-A-4132561 beschrieben)
- nachfolgen: ein Temper-Schritt zwischen 450° C und 800° C, mittels bevorzugt RTP oder im Senkrechtofen, um eine homogene und vollständige Silizierungsreaktion an der Grenzfläche Si/CVD-Ti zu gewährleisten, wie z.B. in der Europäischen Patentanmeldung Nr. 90106139 näher beschrieben.

Zur Lösung dieser Aufgabe ist erfindungsgemäß ein Verfahren vorgesehen, bei dem u.a. die von der Abscheidereaktion räumlich getrennte Anregung von Co-Reaktanten durch eingekoppelte Mikrowellenenergie in reaktive, neutrale Teilchen durchgeführt und diese anschließend dem eigentlichen Reaktor (CVD-System) zugeführt werden ("Remote-Plasma"-CVD). Die prinzipielle Art und das Verfahren der Mikrowellenanregung sind in DE-A-4132560 beschrieben.

Das erfindungsgemäße Verfahren bietet insbesondere die folgenden Vorteile:

Aufgrund des vollständigen Fehlens nichtkonformer, gesputterter Schichten und der Verwendung eines einzogen konformen CVD-Prozesses ist - unter geometrischen Aspekten - derzeit keine technologische Grenze der Einsetzbarkeit zu erkennen. Dies wird begünstigt durch die - im Vergleich z.B. zu CVD-Wolfram - wesentlich glattere Schichtoberfläche (Rauhigkeit des CVD-TiSi₂ < 50 nm). Insbesondere ist diese Kontaktmetallisierung gut kombinierbar mit modernen Verfahren zur globalen Planarisierung wie z.B. CMP (chemical mechanical polishing), die zwangsläufig zu Verbindungslöchern von hohem Aspektverhältnis führen.

Da nur CVD-Ti und CVD-TiSi₂ quasi kontinuierlich in einem Arbeitsgang und in einer CVD-Kammer erzeugt werden, resultieren weniger Kontaktzonen und deswegen niedrigere Übergangswiderstände, was insgesamt zu geringeren Kontaktwiderständen führt.

Insbesondere wird durch den einleitenden, hochkonformen CVD-Ti-Teilschritt ein niederohmiger Kontaktwiderstand sichergestellt, da anders als bei physikalischem Abscheiden auch in Kontakten mit hohem Aspektverhältnis genügend Ti-Metall an die Kontaktzone gebracht werden kann. Dieses Metall bindet aufgrund seiner hohen Affinität zu Sauerstoff eventuell an der Silizium- oder Aluminiumoberfläche vorhandenes Lageroxid und gewährleistet damit eine niederohmige Kontaktierung.

Da die Kontaktmetallisierung quasi in einem einzigen Schritt und in einer einzigen Kammer erzeugt wird, erweist sich das Verfahren insbesondere im Vergleich zu den bekannten als besonders kostengünstig und fertigungsfreundlich. Letzteres trifft entscheidend auch deswegen zu, weil z.B. die mit den selektiven CVD-Verfahren verbundenen fertigungsfeindlichen Risiken (wie übermäßige Grenzflächenreaktionen, Verlust der Selektivität, ungleichmäßiges Auffüllen ungleich tiefer Verbindungslöcher) aufgrund der gewählten Chemie und des gewählten Verfahrens nicht auftreten.

Die erfindungsgemäße Kontaktmetallisierung ermöglicht eine homogenere Verteilung des Stromes über das gesamte Kontaktvolumen und damit auch über die Kontaktfläche, da nur ein Material (vergleiche ansonsten: z.B. Ti/TiN/Al oder /W) verwendet wird. Dadurch wird die Strombelastbarkeit und die Zuverlässigkeit der Kontaktmetallisierung vor allem bei kleinen Lochdurchmessern und hohen Stromdichten im Vergleich zu bekannten Verfahren wesentlich erhöht.

Die Erfindung wird nachfolgend im Zusammenhang mit Ausführungsbeispielen näher erläutert:

Zur Durchführung des erfindungsgemäßen Verfahrens können weitestgehend kommerziell verfügbare CVD-Reaktoren verwendet werden. Besonders geeignet sind z.B. solche CVD-Reaktoren, wie diese in DE-A-4132560 oder EP-90106139 beschrieben sind.

Die Prozeßparameter werden jeweils derart gewählt, daß die Abscheidungen im Bereich der oberflächenkontrollierten Kinetik erfolgen, um ideal konforme Schichten zu erhalten.

### I. CVD-Titanabscheidung:

Optional kann der Abscheidung von CVD-Titan entweder ein sog. Sputteretchschritt (niederenergetische Ar-Ionen; 100 eV) oder ein sog. in-Situ preclean-Schritt vorausgehen, wie z.B. in EP-90106139 näher beschrieben.

Folgende Substanzklassen können entweder direkt oder in Verbindung mit mikrowellenaktivierten Co-Reaktanten zur Titan-CVD-Abscheidung beispielsweise, aber nicht ausschließlich, verwendet werden:
1. Titantetrachlorid = TiCl₄
2. Tetrakisdialkylaminotitan = Ti[NR₂]₄ mit R = Methyl, Ethyl...
3. η⁷-Cycloheptatrienyl- η⁵-cyclopentadienyl-Titan (0) (C₇H₇) Ti (C₅H₅) 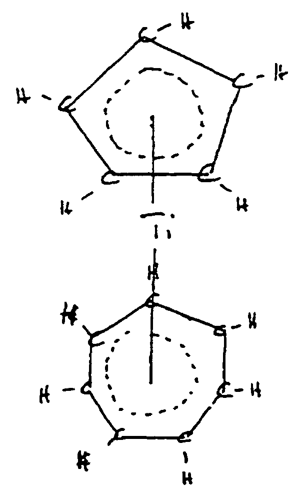
4. η⁸-Cyclooctatestraenyl-η⁵-cyclopentadienyl-Titan (III) (C₈H₈) Ti (C₅H₅) 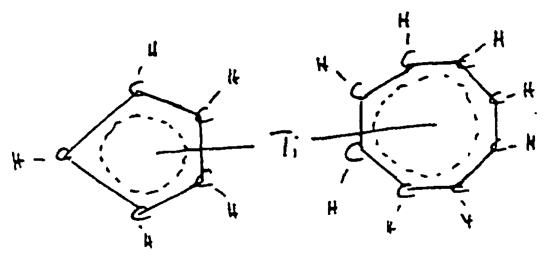
5. Dimere Verbindungen wie z. B. [(R, R')₂Ti (SiH₂)]₂ z.B. mit R, R' = Alkyl, Aryl, C₅H₅, NR₂ mit R = H, CH₃, C₂H₅, .. 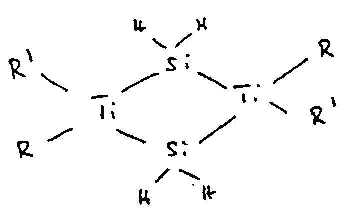
6. Verbindungen des Typs Ti [(CH₂)₂(NR)₂]₂ mit R = H, CH_{3,}C₂H₅, Si (CH₃)₃, ...wie

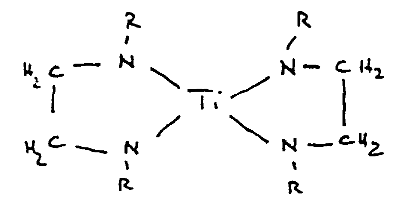

Dabei können hauptsächlich SiH₄, Si₂H₆ und/oder H₂ als Reduktionsmittel (falls erforderlich) eingesetzt werden.

Alle beteiligten Gase können wahlweise durch die externe Mikrowellenanregung aktiviert und separat dem Reaktor zugeleitet werden. Das SiH₄ oder Si₂H₆ und/oder die entsprechende Titanverbindung können aber auch unangeregt vor der sog. Showerhead-Elektrode beigemischt werden.

### Reaktionsgleichung:

z.B. 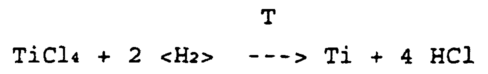 oder z.B.: 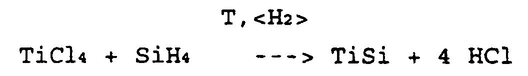 * wobei die eckige Klammer <> bedeutet "angeregt".

### II. CVD-Titansilizidabscheidung:

Optional kann der Abscheidung von CVD-Titan entweder ein sog. Sputteretchschritt (niederenergetische Ar-Ionen; 100 eV) oder ein sog. in-situ preclean-Schritt vorausgehen.

Es können prinzipiell die gleichen Substanzklassen, wie in I. genannt, entweder direkt oder in Verbindung mit mikrowellenaktivierten Co-Reaktanten zur Titandisilizid-CVD-Abscheidung verwendet werden:

### Reaktionsgleichung:

z.B. 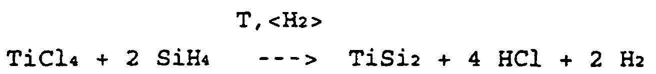 * wobei die eckige Klammer <> bedeutet "angeregt"

### Prozeßparameter:

### Anregung:

| | |
|---|---|
| Mikrowellenleistung | 300 - 850 Watt |
| H₂-Fluß | 0 - 500 sccm |
| Ar- oder He-Fluß | 20 - 150 sccm |
| Druck | 10⁻² - 10⁻¹ Pa |

### Abscheidung:

| | |
|---|---|
| Prozeßtemperatur | 200 - 550°C |
| Verdampfertemperatur | 20 - 140°C |
| Trägergs | Ar, He, H₂ |
| Trägergasfluß | 0 - 100 sccm |
| (SiH₄ oder Si₂H₆ Fluß | 0 - 200 sccm) |
| (RF-Leistung | 200 - 800 Watt) |
| (Elektrodenabstand | 0.3 - 2.5 cm) |

### III. Ätzprozeß:

Die CVD Ti/TiSi₂-Schicht kann entweder durch den im folgenden beschriebenen Prozeß soweit rückgeätzt werden, daß nur in den Verbindungslöchern Ti/TiSi₂-Stöpsel verbleiben oder mit den üblichen Fototechnik-/Ätzschritten strukturiert werden.

Alternativ kann anstelle des Rückätzschrittes das auf der horizontalen Oberfläche sich befindende TiSiz auch durch einen CMP-Schritt (Chemical Mechanical Polishing) entfernt ("zurückgeschliffen") werden.

### III.1. Rückätzprozeß:

Der Rückätzprozeß besteht bevorzugt aus einem "bulk-Ätzschritt", mit dem ca. 90 % der auf den horizontalen Isolatorflächen abgeschiedenen Schicht isotrop geätzt werden. In einem zweiten, stärker anisotropen "overetch-Schritt", der eine hohe Selektivität zur Isolatorschicht und einen minimalen Loadingeffekt aufweist, wird der entsprechende "plug" (Stöpsel) erzeugt.

| Prozeßparameter: | bulk-Ätzschritt | Overetch Anisotropes Strukturieren | |
|---|---|---|---|
| Cl₂ /sccm | 30 - 200 | 10 - 150 | 30 - 200 |
| HBr/sccm | 5 - 100 | 5 - 50 | 5 - 100 |
| Ar /sccm | 10 - 100 | 10 - 100 | 10 - 100 |
| N₂ /sccm | -- -- | -- -- | 0 - 50 |
| Druck/mTorr | 100 - 300 | 5 - 250 | 100 - 300 |
| Leistung/Watt | 200 - 500 | 50 - 400 | 200 - 500 |
| Kathodentemp./°C | 10 - 50 | 10 - 50 | 10 - 50 |
| Magnetfeld/Gauss | 0 - 150 | 0 - 150 | 0 - 150 |

### Literatur:

/ 1/ P. E. Riley and T. E. Clark
   J. Electrochem. Soc. Vol. 138, No. 10 (1991) S. 3008.
/ 2/ Europäische Patentanmeldung Nr. 90106139
/ 3/ I. J. Raaijmakers and A. Sherman
   Proceedings 7th International IEEE VLSI Multilevel
   Interconnection Conference, Santa Clara, 1990
/ 4/ E. K. Broadbent
   J. Vac. Sci. Technol. B5 (6), (1987), S. 1661.
/ 5/ T. Amazawa, H. Nakamura und Y. Aita
   Tech. Digest IEEE International Electron Devices Meeting (1987), S. 217.
/ 6/ C. Bernard, R. Madar und Y. Pauleau
   Solid State Technology, Febr. 1989, S. 79.
/ 7/ G. N. Parsons, Appl. PHys. Lett. 59 (20) (1991), S. 2546.
/ 8/ J. F. Million Brodaz et. al.
   Proc. 6th European Conference on CVD
   R. Porat, Ed. (1987) S. 280.
/ 9/ A. Bouteville, A. Royer und J. C. Remy
   J. Electrochem. Soc., Vol. 134 No. 8 (1987) S. 2080
/10/ DE-A-4132560
/11/ B. Aylett
   Mat. Res. Soc. Symp. Proc., Vol. 131 (1989).
/12/ B. Aylett
   Transformation of organometallics into common and exotic material : design and activation
   R. M. Laine ed., M. Nijhoff publ. (1988) S. 165-177
/13/ B. J. Aylett
   J. Organometallic Chem. Lib., 9, 327 (1978)
/14/ DE-A-4132561
   H. Steinhardt, Fa. SECON, Wien
   K. Hieber, E. Bußmann, SIEMENS AG, München
/15/ P. Burggraaf
   Semiconductor International, Dezember 1990, S. 28.

## Patentansprüche

1. Verfahren zur Metallisierung von Submikron-Kontaktlöchern in Halbleiterkörpern, bei denen in das Submikron-Kontaktloch Metall durch einen einzigen CVD-Prozess innerhalb einer einzigen CVD-Kammer abgeschieden wird,
**dadurch gekennzeichnet, dass** zunächst eine Ti- oder TiSi-Schicht abgeschieden un unmittelbar darauf eine TiSi₂-Schicht abgeschieden wird.

2. Verfahren nach Anspruch 1, **dadurch gekennzeichnet, dass** die TiSi₂-Schicht unmittelbar nach dem Abscheiden der Tioder TiSi-Schicht ohne Vakuumunterbrechung abgeschieden wird.

3. Verfahren nach einem der Ansprüche 1 oder 2, **dadurch gekennzeichnet, dass** die Ti- oder TiSi-Schicht eine Dicke von 5 bis 100 nm aufweist.

4. Verfahren nach einem der Ansprüche 1 bis 3, **dadurch gekennzeichnet, dass** die TiSi₂-Schicht einen Widerstandswert pro Fläche von 20 bis 40 µΩcm aufweist.

5. Verfahren nach einem der Ansprüche 1 bis 4, **dadurch gekennzeichnet, dass** zur Vollendung der Metallisierung ein Rückätzprozess durchgeführt wird, mit dem die auf horizontalen Isolatorflächen abgeschiedenen Ti/TiSi₂- oder TiSi/TiSi₂-Schichten wieder entfernt werden.

6. Verfahren nach einem der Ansprüche 1 bis 4, **dadurch gekennzeichnet, dass** zur Vollendung der Metallisierung ein CMP-Schritt durchgeführt wird, mit dem die auf horizontalen Isolatorflächen abgeschiedenen Ti/TiSi₂- oder TiSi/TiSi₂-Schichten wieder entfernt werden.

7. Verfahren nach einem der Ansprüche 1 bis 6, **dadurch gekennzeichnet, dass** eine Kontaktierung des metallisierten Kontaktloches durch Aufbringen und Strukturieren von AlSi oder TiN/AlSiCu erfolgt.

8. Verfahren nach Anspruch 7, **dadurch gekennzeichnet, dass** das Aufbringen des AlSi oder TiN/AlSiCu durch Sputtern erfolgt.

9. Verfahren nach einem der Ansprüche 1 bis 8, **dadurch gekennzeichnet, dass** die Ti/TiSi₂- oder TiSi/TiSi₂-Schicht gleichzeitig mit bekannten Lithographie-/Ätzverfahren strukturiert wird.

10. Verfahren nach einem der Ansprüche 1 bis 9, **dadurch gekennzeichnet, dass** vor der Metallisierung der Submikron-Kontaktlöcher eine Reinigung der Kontaktzone erfolgt.

11. Verfahren nach Anspruch 10, **dadurch gekennzeichnet, dass** die Reinigung der Kontaktzonen nasschemisch oder trocken erfolgt.

12. Verfahren nach einem der Ansprüche 1 bis 11, **dadurch gekennzeichnet, dass** nach der Metallisierung des Submikron-Kontaktloches ein Temper-Schritt zwischen 450°C und 800° C durchgeführt wird.

13. Verfahren nach einem der Ansprüche 1 bis 12, **dadurch gekennzeichnet, dass** die von der Abscheidereaktion räumlich getrennte Anregung von Co-Reaktanten durch eingekoppelte Mikrowellenenergie in reaktive, neutrale Teilchen durchgeführt und diese anschließend der CVD-Kammer zugeführt werden.

## Claims

1. Process for the metallization of submicron contact holes in semiconductor bodies, in which metal is deposited into the submicron contact hole by means of a single CVD process inside a single CVD chamber, **characterized in that** a Ti or TiSi layer is deposited first of all, and a TiSi₂ layer is deposited directly thereon.

2. Process according to Claim 1, **characterized in that** the TiSi₂ layer is deposited immediately after the deposition of the Ti or TiSi layer, without any interruption to the vacuum.

3. Process according to one of Claims 1 or 2, **characterized in that** the Ti or TiSi layer has a thickness of from 5 to 100 nm.

4. Process according to one of Claims 1 to 3, **characterized in that** the TiSi₂ layer has a resistivity of 20 to 40 µΩcm.

5. Process according to one of Claims 1 to 4, **characterized in that** to complete the metallization an etchback process is carried out, by means of which the Ti/TiSi₂ or TiSi/TiSi₂ layers which have been deposited on horizontal insulator surfaces are removed again.

6. Process according to one of Claims 1 to 4, **characterized in that** to complete the metallization a CMP step is carried out, by means of which the Ti/TiSi₂ or TiSi/TiSi₂ layers which have been deposited on horizontal insulator surfaces are removed again.

7. Process according to one of Claims 1 to 6, **characterized in that** contact is made with the metallized contact hole by the application and patterning of AlSi or TiN/AlSiCu.

8. Process according to Claim 7, **characterized in that** the AlSi or TiN/AlSiCu is applied by sputtering.

9. Process according to one of Claims 1 to 8, **characterized in that** the Ti/TiSi₂ or TiSi/TiSi₂ layer is patterned simultaneously using known lithography/etching processes.

10. Process according to one of Claims 1 to 9, **characterized in that** the contact zone is cleaned prior to the metallization of the submicron contact holes.

11. Process according to Claim 10, **characterized in that** the cleaning of the contact zones is wet-chemical or dry.

12. Process according to one of Claims 1 to 11, **characterized in that** a conditioning step is carried out at between 450°C and 800°C after the metallization of the submicron contact hole.

13. Process according to one of Claims 1 to 12, **characterized in that** the excitation of co-reactants, which is spatially separate from the deposition reaction, is carried out by the introduction of microwave energy into reactive, neutral particles, and these are then fed to the CVD chamber.

## Revendications

1. Procédé de métallisation de trous de contact de dimension inférieure au micron dans des corps semi-conducteurs, dans lesquels on dépose dans le trou de contact de dimension inférieure au micron du métal par une opération CVD unique dans une chambre CVD unique,
**caractérisé en ce que** l'on dépose d'abord une couche de Ti ou une couche de TiSi et immédiatement ensuite une couche de TiSi₂.

2. Procédé suivant la revendication 1, **caractérisé en ce que** l'on dépose la couche de TiSi₂ immédiatement après le dépôt de la couche de Ti ou de la couche TiSi sans interrompre le vide.

3. Procédé suivant l'une des revendications 1 ou 2, **caractérisé en ce que** la couche de Ti ou la couche de TiSi a une épaisseur de 5 à 100 nm.

4. Procédé suivant l'une des revendications 1 à 3, **caractérisé en ce que** la couche de TiSi₂ a une résistance par surface de 20 à 40 µΩcm.

5. Procédé suivant l'une des revendications 1 à 4, **caractérisé en ce que**, pour achever la métallisation, on effectue une opération d'attaque en retour par laquelle on élimine à nouveau les couches de Ti/TiSi₂ ou de TiSi/TiSi₂ déposées sur des surfaces horizontales isolantes.

6. Procédé suivant l'une des revendications 1 à 4, **caractérisé en ce que**, pour achever la métallisation, on effectue un stade CMP par lequel on élimine à nouveau les couches de Ti/TiSi₂ ou de TiSi/TiSi₂ déposées sur des surfaces horizontales isolantes.

7. Procédé suivant l'une des revendications 1 à 6, **caractérisé en ce que** l'on effectue une mise en contact des trous de contact métallisés par dépôt et structuration d'AlSi ou de TiN/AlSiCu.

8. Procédé suivant la revendication 7, **caractérisé en ce que** l'on effectue le dépôt du AlSi ou du TiN/AlSiCu par pulvérisation cathodique.

9. Procédé suivant l'une des revendications 1 à 8, **caractérisé en ce que** l'on structure la couche de Ti/TiSi₂ ou de TiSi/TiSi₂ simultanément par des procédés connus de lithographie et d'attaque.

10. Procédé suivant l'une des revendications 1 à 9, **caractérisé en ce qu'**avant la métallisation des trous de contact de dimension inférieure au micron, on effectue un nettoyage de la zone de contact.

11. Procédé suivant la revendication 10, **caractérisé en ce que** l'on effectue le nettoyage des zones de contact en voie chimique humide ou en voie sèche.

12. Procédé suivant l'une des revendications 1 à 11, **caractérisé en ce qu'**après la métallisation du trou de contact de dimension inférieure au micron, on effectue un stade de recuit entre 450°C et 800°C.

13. Procédé suivant l'une des revendications 1 à 12, **caractérisé en ce que** l'on effectue l'excitation séparée dans l'espace de la réaction de dépôt de coréactifs par injection d'énergie micro-onde dans des particules réactives neutres que l'on envoie ensuite à la chambre CVD.
